# EUROPEAN PATENT SPECIFICATION

(11) **EP 0 370 693 B1**
(45) Date of publication and mention of the grant of the patent: **06.04.1994**
(21) Application number: 89311861.2
(22) Date of filing: 16.11.1989
(51) Int. Cl.: G03F 7/029, C07C 381/12, C07F 9/00

(54) **Novel onium salts and the use thereof as photoinitiators**
Oniumsalze und ihre Verwendung als Photoinitiatoren
Sels onium et leur utilisation comme photoinitiateur

(30) Priority: 21.11.1988 US 273788
(43) Date of publication of application: 30.05.1990
(73) Proprietor: EASTMAN KODAK COMPANY, Rochester, New York 14650-2201 (US)
(72) Inventor: Saeva, Franklin Donald c/o EASTMAN KODAK COMPANY, Rochester New York 14650 (US); Breslin, David Thomas c/o EASTMAN KODAK COMPANY, Rochester New York 14650 (US)
(74) Representative: Baron, Paul Alexander Clifford

(56) References cited:
- EP-A- 0 035 969
- GB-A- 2 180 240
- RESEARCH DISCLOSURE. no. 289, May 1988, HAVANT GB pages 298 - 299; "Novel Sulfonium Salts And The Use Thereof As Photoinitiators"

## Description

This invention relates to certain novel onium salts and, more particularly, to light sensitive onium salts. It also relates to the use of such salts as photoinitiators.

It is well known that various onium salts, upon exposure to radiation, are capable of forming a Bronsted acid, and that the Bronsted acid thus formed can cure a wide variety of materials. See, for example, UV Curing: Science and Technology, edited by S. Peter Pappas and published (1978) by Technology Marketing Corporation, 64 Westover Road, Stamford, Connecticut 06902. The problem with such salts is that they do not absorb visible radiation, and commonly must be used in combination with a light-absorbing photosensitizer in order to carry out visible light, e.g., laser, induced photoinitiation.

Research Disclosure Vol. 289, May 1988, page 298, published by Kenneth Mason Publications Ltd., London, England, describes sulfonium salts and oxysulfonium salts which, upon exposure to visible radiation, undergo irreversible intramolecular rearrangement to form a Bronsted acid. The light-absorbing capability of these sulfonium and oxysulfonium salts depends upon resonance (i.e., π resonance) throughout the molecule. The photo products of these salts absorb at shorter wavelengths than the starting sulfonium and oxysulfonium salts.

It is an object of this invention to provide onium salts which absorb visible radiation to form a Bronsted acid.

Onium salts satisfying the object of the invention include sulfonium, arsonium, ammonium and phosphonium salts comprising:
a chromophore which absorbs visible radiation, said chromophore exhibiting a higher energy occupied molecular orbital that at least one other substituent attached to the S, As, N or P atom of said salt;
an insulating group which links said chromophore to the S, As, N or P atom of said salt, said insulating group preventing π resonance between said chromophore and the other substituents in said salt;
at least one substituent comprising an electron withdrawing group and exhibiting a lower unoccupied molecular orbital than said chromophore; and,
an anion;
said salts being capable, upon exposure to visible radiation, of forming a Bronsted acid.

A specific advantage of such salts is that a chromophore can be selected which matches the desired exposing radiation, such as a visible laser, e.g., argon ion (488/515 nm), nitrogen ion (423 nm), copper vapor (510/578 nm), e-beam pumped CdS (494 nm) and the He-Ne laser 632 nm.

The onium salts of this invention comprise a chromophore, i.e., a covalently unsaturated group responsible for electronic absorption, and which absorbs visible light. The chromophore is chemically linked to the remainder of the salt by an insulating group which prevents π resonance between the chromophore and the rest of the salt. Preferably, the chromophore is non-basic and the conjugate acid has a pKa of from 0 to -20. Advantageously, the chromophore has a hydroxy, nitrile, carbonyl or carboxy group, or an ether or ester group which in its protonated form would be a strong acid as previously defined.

The preferred onium salts of this invention are sulfonium salts. Arsonium salts are also highly useful. Both the sulfonium and arsonium salts can be used without a separate proton source material, such as water, an amine or an alcohol. Such proton source materials are employed when the onium salt is an ammonium or phosphonium salt. When the ammonium and phosphonium salts of this invention are exposed to visible radiation, an intermolecular reaction occurs which results in the formation of a Bronsted acid comprising the anion of the salt and the proton from the proton source material.

The sulfonium and arsonium salts of this invention preferably comprise a chromophore which has a releasable, positive hydrogen ion. Upon exposure to visible radiation, an intramolecular rearrangement occurs which results in the formation of a Bronsted acid comprising the anion of the salt and the removable positive hydrogen ion. However, sulfonium and arsonium salts can comprise a chromophore which does not contain a removable, positive hydrogen ion. Such salts are advantageously used in combination with a protonating agent and form, upon exposure to visible radiation, a Bronsted acid comprising the anion of the salt and the proton from the proton source material. The Bronsted acid is formed by an intermolecular reaction between the salt and the protonating material.

A particularly preferred class of onium salts is represented by the following formula: 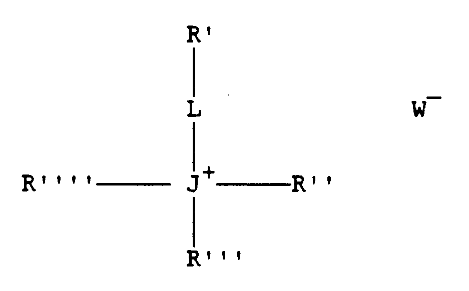
wherein:
R′ represents an electron donating chromophore which absorbs visible radiation and which exhibits a higher energy occupied molecular orbital than at least one of R˝, R‴ and R˝˝ such as a coumarin group, preferably a hydroxy, methoxy or carboxy substituted coumarin group; a bifluoroenylidene group, an anthracene group; a naphthacene group or a carbocyanine group, which groups can be further substituted with a group, such as methoxy, methyl, phenoxy, and thiomethyl to extend absorption of the chromophore to longer wavelength radiation or to fine tune the electronic absorption behavior of R′;
L represents a linking group which prevents π resonance between R′ and the remainder of the compound, and is preferably an optionally substituted alkylene linkage, advantageously containing from 1 to 18 carbon atoms, such as methylene, ethylene, propylene, butylene etc.; an ester linkage; an amide linkage, an arylene linkage such as a phenylene linkage; a sulfonate ester linkage, or, a sulfonamide linkage;
R˝ represents the same substituent as R′ or R‴, or an optionally substituted aryl group such as a phenyl group or a naphthyl group, or an optionally substituted alkyl group, advantageously having from 1 to 18 carbon atoms;
R‴ represents an electron withdrawing alkyl, aryl or heterocyclic group, such as optionally substituted alkyl groups having from 1 to 18, and most preferably 1 to 4 carbon atoms; optionally substituent aryl groups have from 6 to 10 carbon atoms, and most preferably a phenyl group; and optionally substituent heterocyclic groups having from 1 to 4 rings and containing from 1 to 3 hetero atoms, such as N, S, O, Se or Te; preferably the R‴ group contains an electron withdrawing group, such as halogen, preferably F, Cl or Br; CN, NO₂, -SO₂-, CF₃ and the like;
J represents an S, As, N or P atom;
when J represents As, N or P, R˝˝ represents the same substituent as R′, R˝ or R‴; and, when J represents an S atom, R˝˝ represents either O or an electron pair; and,
W⁻ represents an anion capable of forming a Bronsted acid preferably having a pKa of less than 7,
such as BF₄⁻, Cl0₄⁻, AsF₆⁻, PF₆⁻, CH₃SO₃⁻. CF₃SO₃⁻, FeCl₄⁻, BiCl₄⁻², SnCl₆⁻³, AlF₆⁻³, GaCl₄⁻, TiF₆⁻, ZrF₆⁻, SbF₆⁻, or p-toluenesulfonate,
said salt being capable, upon exposure to visible radiation of a wavelength absorbed by said chromophore, of forming a Bronsted acid. It will be noted that the salts of the invention can contain two electron donating chromophore groups, or two electron withdrawing groups.

Some highly preferred compounds are those in which, referring to the above formula:
R′ represents one of the following chromophores: 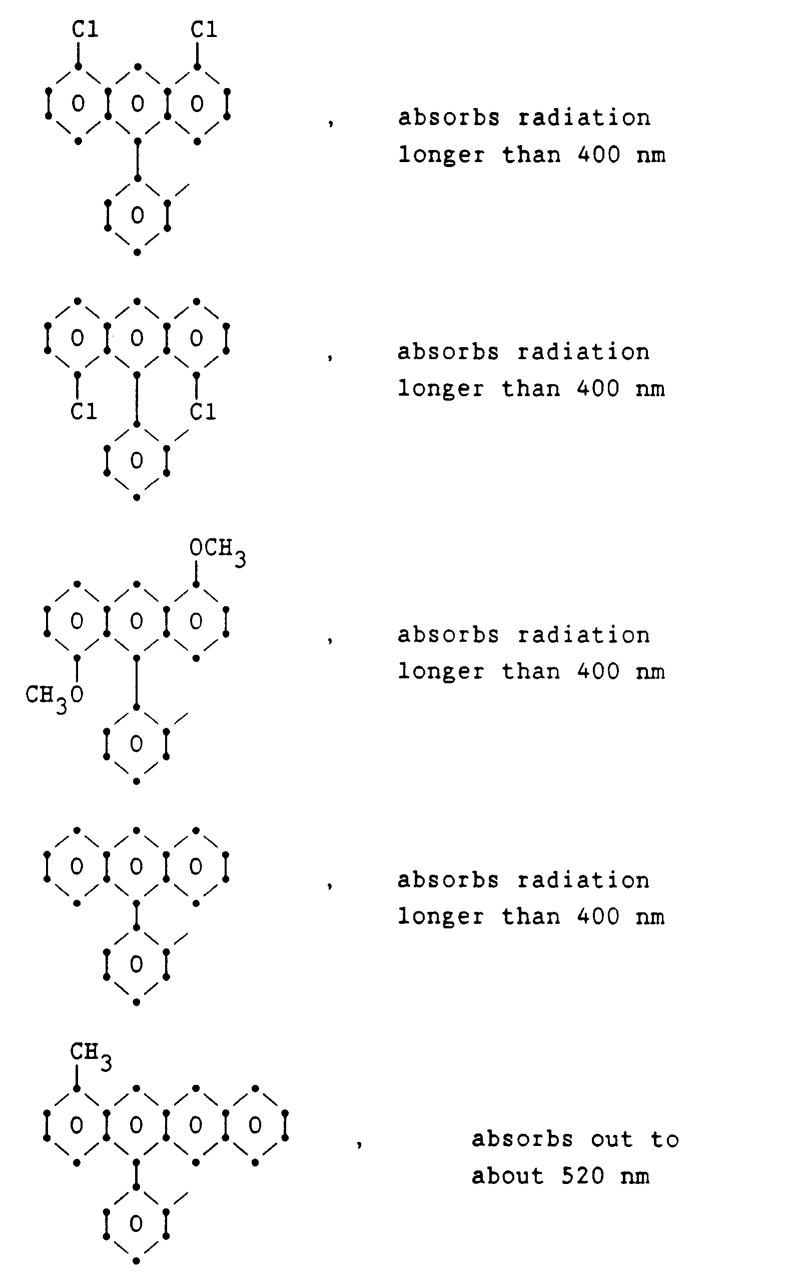 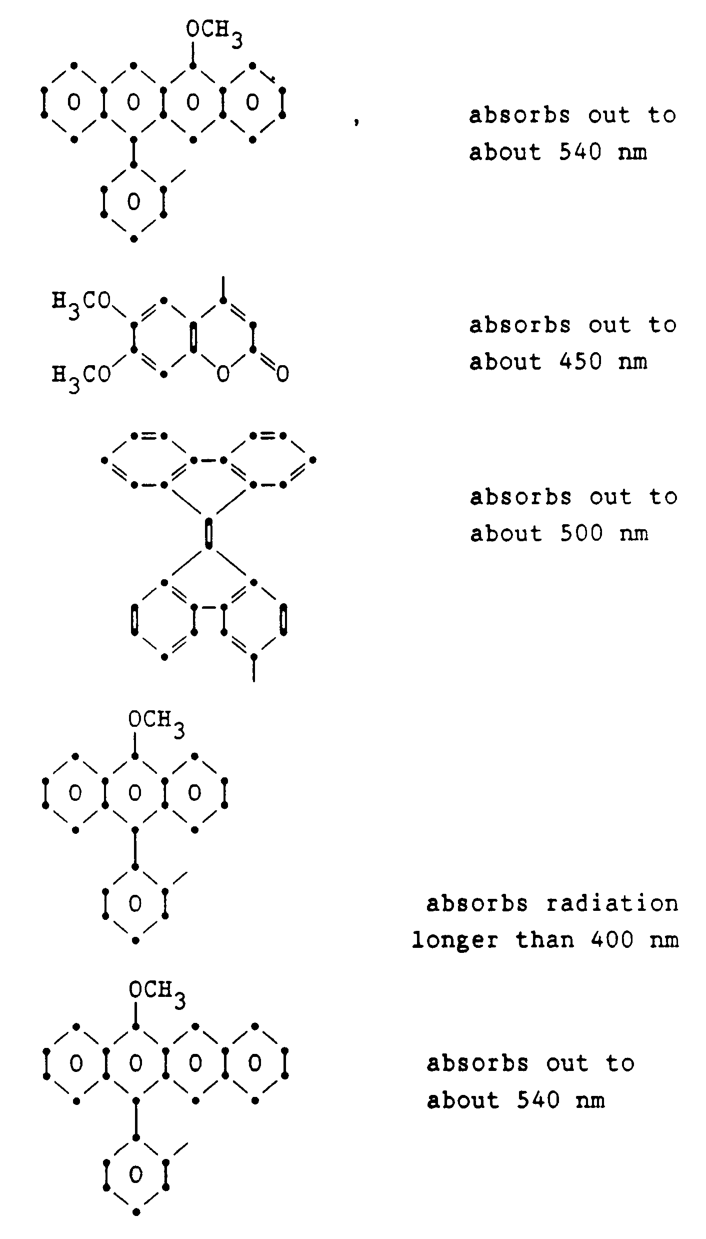 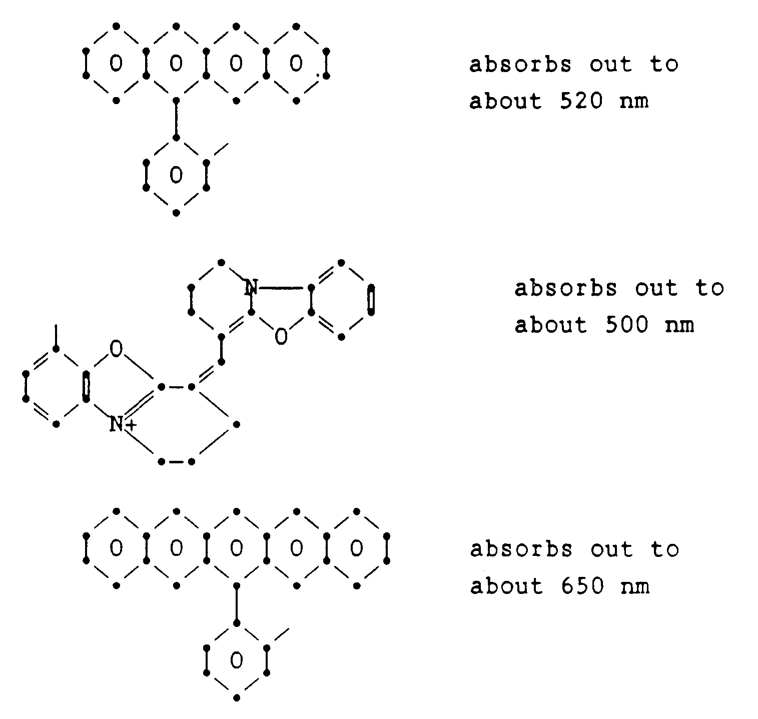
L represents one of the following linkages:

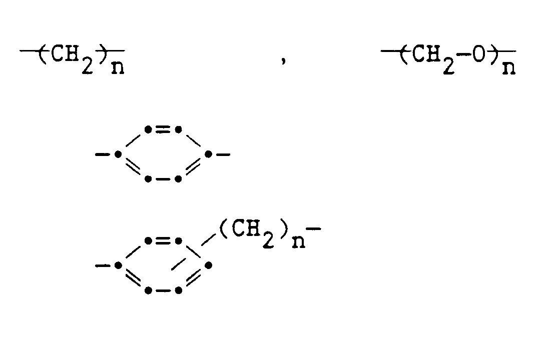

-CO₂-

-CONH-

wherein n represents 1 to 12;
J, R'', R''' and R'''', taken together, represent one of the following groups: 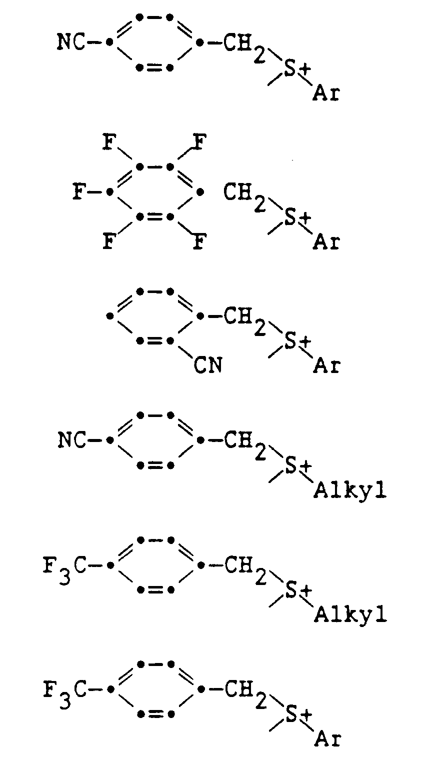
wherein Ar represents an optionally substituent aryl group, such as phenyl or naphthyl and alkyl represents an alkyl group such as methyl, ethyl, n-propyl or i-butyl; and
W represents BF₄, ClO₄, AsF₆, PF₆, CF₃SO₃. CH₃SO₃, SnCl₄, FeCl₄, BiCl₄ and SbF₆.

The onium salts of this invention can be used in any application where it is desirable to release a Bronsted acid. The subject salts are especially useful in compositions which are curable by a Bronsted acid. Such compositions, also called cationically curable compounds, include cyclic formals and acetals, vinyl ethers, cyclic ethers, lactones, polysiloxanes, ureaformaldehyde resins, melamine-formaldehyde resins, and epoxides. A more comprehensive list is detailed in Cationic Polymerization of Olefins: A Critical Inventory J. P. Kennedy, Wiley Interscience Pub. 1975. Epoxy resins are particularly preferred.

The useful epoxy resins preferably contain a plurality of epoxy groups and may be based on the reaction product of Bisphenol A (i.e. 2,2-bis(4-hydroxyphenyl)propane) and epichlorohydrin, e.g. the resins sold under the registered Trademark Araldite by Ciba-Geigy Ltd., or are the reaction product of epichlorohydrin with a phenol-formaldehyde resin of relatively low molecular weight, e.g. epoxy-Novolaks (available, for example from Dow), or other modified epoxy resins as disclosed in UV Curing: Science and Technology (cited above). Still other useful epoxy resins and ether-containing materials polymerizable to a higher molecular weight are listed in Berggren et al U.S. Patent 4,291,114 (1981) col. 4 line 37 through col. 6 line 23 and the silicone curable compositions disclosed by Eckberg U.S. Patent 4,547,431 (1985) col. 3 line 29 through col. 4 line 17.

The onium salts of the invention can comprise from 0.1 to 30, and preferably from 5 to 25 percent by weight of the curable composition.

The onium salts of the invention can be used to provide protective coatings by imagewise or non-imagewise polymerization of monomers, e.g., the epoxide or ether containing monomers referred to above. The present onium salts can be used advantageously to provide overcoats for optical recording elements, such as those described by Thomas et al U.S. Patent 4,380,769 issued April 19, 1983. Such recording elements have on a support, in order, a smoothing layer, a reflection layer, a heat-deformable optical recording layer and a protective overcoat layer.

The onium salts of this invention are useful in making printing plates. For example, the onium salts of this invention and a material which can be chemically modified by a Bronsted acid can be solvent coated as a film onto an aluminum substrate. After the film has dried, it can be exposed to light absorbed by the chromophore of the onium salt, thus releasing a Bronsted acid. The film can be developed to produce a relief image by heating to vaporize chemical fragments from the exposed areas. The relief image can be inked and the resulting plate can be used as a printing plate. The relief image should be capable of being inked and capable of transferring the ink to a substrate, such as paper.

The onium salts of the invention can also be used in photoelectrographic elements which have a conductive layer in contact with an acid generating layer which contains an onium salt of the invention (the acid generating layer being free of photopolymerizable monomer), as described in Molaire et al U.S. Patent 4,661,429. Such elements can be imagewise exposed, the acid photogenerating layer can be electrostatically charged, and the resultant electrostatic image can be developed with charged toning particles. Also, the onium salts of the invention can be used in the electrophotographic elements and process described in Scozzofava et al U.S. Patent 4,485,161 issued November 27, 1984.

The onium salts of the invention can also be used in the method of making color filter arrays which is described by Molaire et al U.S. Patent 4,650,734. In that method, an electrophotographic element having a conductive layer in electrical contact with an acid photogenerating layer comprising an electrically insulating binder and being free of photopolymerizable materials, is imagewise exposed and electrostatically charged to form a latent image, and the latent image is developed with colored toner particles to form a single color array. Those steps can be repeated, with different colored toners to produce a multicolored filter array.

The onium salts of this invention are particularly useful as photoinitiators to produce imagewise release of chemical fragments in a polymer system for photoresist or printing plate applications.

The following examples are included for a further understanding of the invention.

The compounds of this invention can be prepared conveniently by the following reaction: 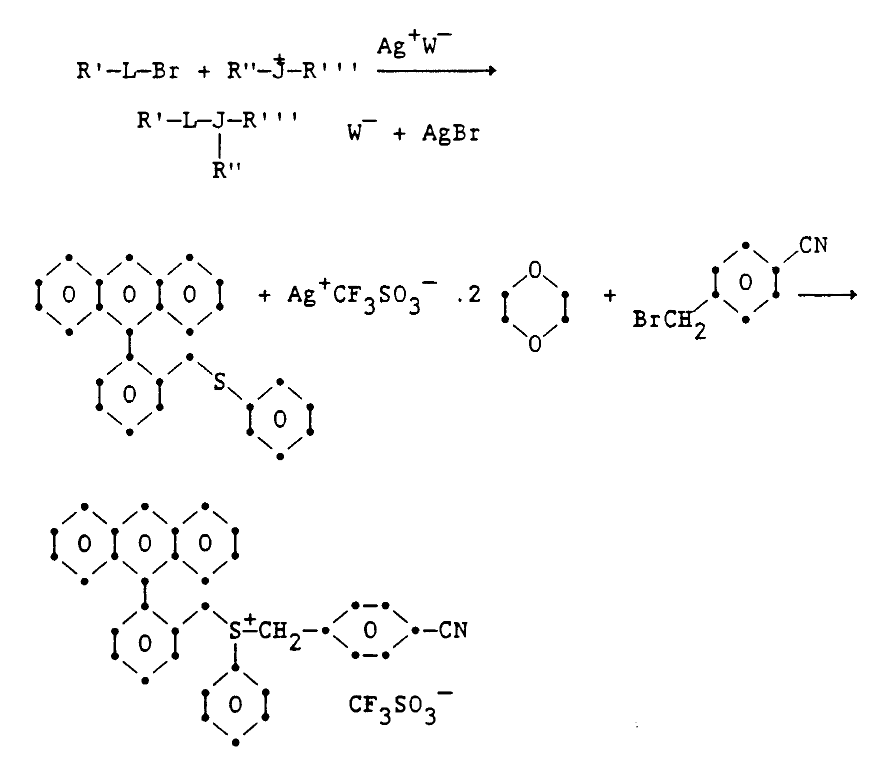
In a 100 ml round bottom flask was placed 2.00 gms. of the anthrylsulfide and 1.1 grams of p-cyanobenzyl bromide. To the solid mixture was added 30 ml of methylene chloride. A solution was formed. To the solution was added 2.4 grams of the appropriate silver salt. The reaction was allowed to stir overnight. An H¹NMR spectrum indicated about 80% conversion with no benzyl bromide present. The precipitated silver salts were filtered off. The methylene chloride solvent was removed by evaporation. To the semi-solid was added 5 mls of chloroform. The chloroform solution was dropped into 300 mls of carbontetrachloride, the product oiled out. The carbon tetrachloride was decanted off and the product dissolved in acetonitrile. The acetonitrile solution was dropped into diethyl ether (100 ml). The product as off white solid was collected by filtration; the yield was 2.55 gms. The crude was recrystalized from CH₃CN/ether MP-127-130°C (dec). 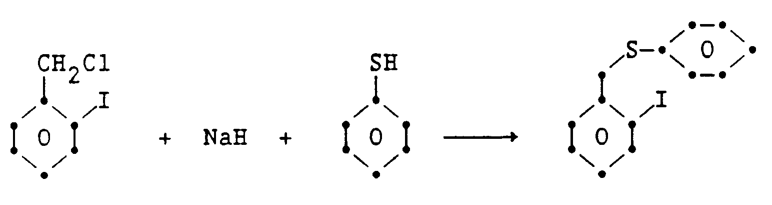
In a 250 ml 3 neck round bottom flask was placed 26 grams of sodium hydride. The hydride was washed with cyclohexane and then suspended in 100 mls of anhydrous THF (tetrahydrofuran). Then a solution of 4.4 grams of the thiophenol in 50 mls of THF was added dropwise over 1/2 hour, and allowed to stir for an additional 1/2 hour. Then a solution of 2-iodobenzylchloride 10 grams in 50 mls of THF was added. After 30 minutes the reaction was quenched with 10 mls of 10% HCl. Then ∼200 mls of diethyl ether was added. The ether layer was extracted with dilute NaOH, and then with water. The ether layer was dried over MgSO₄ and flash evaporated to yield 12.5 grams of crude material. The crude product was distilled under vacuum. The product had a boiling point of 145-150°C. (0.5 mmHg). 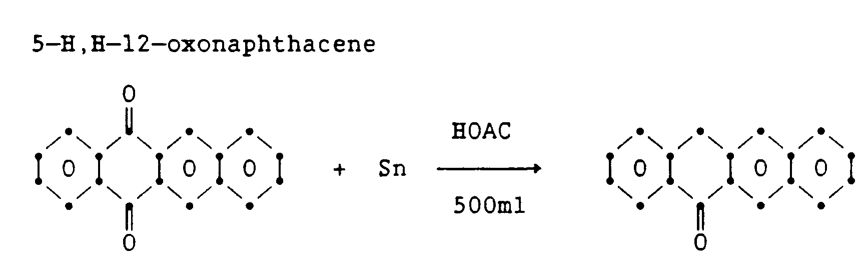
In a 1 ℓ single neck round bottom was placed 20 grams of the 5,12-naphthacenequinone, 40 grams of Sn, and 500 mls of acetic acid. The mixture was refluxed for 1 1/2 hours. Then 40 mls of concentrated HCl was added. The mixture was allowed to cool and the product was collected by suction filtration. Crude yield was 17 grams. Recrystallization from toluene provided 15 gm of purified product. 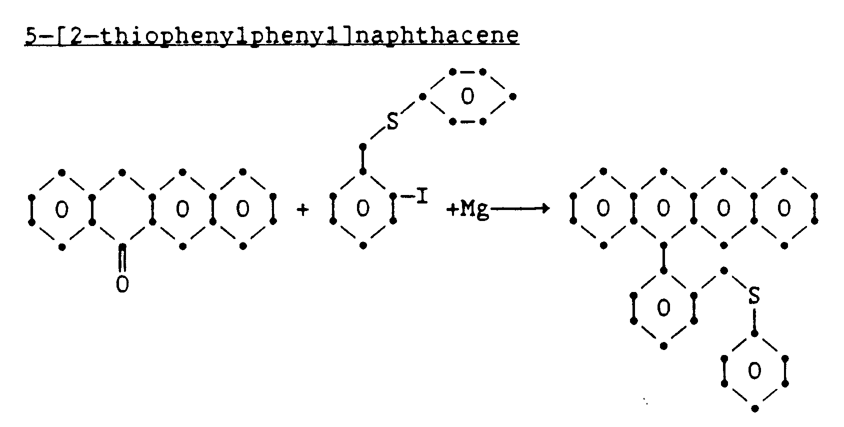
The Grignard reagent was formed by placing the iodide, Mg, and 50 mls of anhydrous THF in a 100 ml round bottom flask and allowing the mixture to reflux for 4 hours. Then the 5-H,H-12-oxonaphthacene was added as a solid and the purple mixture was heated at reflux for 3 hours. The mixture was allowed to stir overnight at room temperature before adding 10 mls of concentrated HCl to the reaction mixture. The solution was heated at reflux for 15 minutes and cooled to room temperature. The reaction mixture was extracted with diethylether and the combined ether layers were extracted with 100 ml of 10% sodium carbonate, and then with water. The ether solution was dried with MgSO₄, filtered and flash evaporated. The solid was slurred in a small amount of EtOH and filtered. The crude product yield was 1.05 grams.

### 4-Cyanobenzyl-2-[5-naphthacenyl]benzylphenylsulfonium trifluoromethane sulfonate.

In a 15ml round bottom flask was placed 0.1 gm (0.23 mmole) of 5-[2-thiophenylmethylphenyl]naphthacene, 0.05 gm (0.25 mmole) of p-cyanobenzylbromide, and 5 ml of methylenechloride. Then 0.11 gm of silver trifluoromethane sulfonate di-dioxane was added and the reaction was allowed to stir for twenty four hours at room temperature. The methylene chloride was evaporated and 1 ml of acetonitrile was added. The insoluble silver salts were removed by filtration. The solution was then added to 150 ml of diethyl ether. The crude product crystallized and was collected by filtration. The product yield of 4-cyanobenzyl-2-[5-naphthacenyl]benzylphenyl sulfonium trifluoromethane sulfonate was 0.1 gm.

### 2-(5-naphthacenyl]benzylmethyl ether (A)

The Grignard reagent from 2-bromobenzylmethyl ether was prepared by adding magnesium to a solution of 2-bromobenzylmethyl ether in anhydrous THF and refluxing for 24 hours. Then the 5-oxo-12(H,H)-dihydronaphthacene was added as a solid. The solution was refluxed for 3 hours and cooled prior to the addition of concentrated HCl. The mixture was refluxed for an additional hour. Once the reaction mixture cooled to room temperature it was extracted with diethyl ether. The organic layer was then washed with a 10% bicarbonate solution, and finally with H₂O. The ether solution was dried with MgSO₄, filtered and flash evaporated to yield the crude product. The crude product was recrystallized from ethanol.

### 2-[5-napthacenyl]benzylbromide (B)

A solution of (A) in chloroform is treated with a steady stream of hydrogen bromide gas for 8 hours, and then allowed to stir for 16 hours. The reaction was washed with a bicarbonate solution, and with H₂O. The chloroform was dried with MgSO₄, and flash evaporated. The crude product was recrystallized from cyclohexane.

### 4-cyanobenzyl-2-[5-naphthacenyl]benzyldimethyl ammonium bromide. (C)

A mixture of (B) and N,N-dimethyl-4-cyano benzylamine in acetonitrile was refluxed for 2 hours. The reaction mixture was then poured into diethyl ether, and the crude product was collected by filtration. The crude product was recrystallized from ethanol. The same reaction can be used to prepare the corresponding phosphonium and arsonium salts.

The following examples show the use of the salts of the invention to produce the imagewise release of chemical fragments in a polymer system for photoresist applications.

### Example 1 Imagewise Release of a Chemical Fragment

4-cyanobenzyl-2-[5-naphthacenyl]benzylphenyl sulfonium trifluoromethane sulfonate (I) (10% by weight) was dissolved in sufficient acetonitrile solvent along with polyvinyl (4-t-butylphenylcarbonate) as host polymer (90% by weight) to make a homogeneous solution. A film of the polymer-photoacid composition was cast onto a silicon wafer. The film was then irradiated in an imagewise fashion with an argon ion laser emitting at 488/515 nm. In the irradiated areas a Bronsted acid was produced which catalyzed the thermal transformation of the original polymer to polyvinylphenol after heating at 100°C for 5-15 minutes. The regions containing the polyvinylphenol were then selectively removed with an aqueous base solution (10-50% hydroxide solution).

### Example 2 Imagewise Release of a Silane Chemical Fragment

4-cyanobenzyl-2-[5-naphthacenyl]benzylphenyl sulfonium trifluoromethane sulfonate (I) (10% by weight) was dissolved in sufficient dichloromethane along with a polymer containing pendant allyl-t-butyldimethyl silyl groups (90% by weight) to make a homogeneous solution. A film of the polymer-photoacid composition was cast onto a silicon wafer. The film was then irradiated in an imagewise fashion using an argon ion laser emitting at 488/515 nm. In the irradiated area a Bronsted acid was produced which catalyzed the thermal transformation to the vinyl polymer without the pendant silane functionality. Exposure of the irradiated and heated film to an oxygen plasma selectively removed the irradiated areas by a completely dry process.

Results similar to those described in the above examples can be obtained with other sulfonium and arsonium salts of the type described above. Also, by employing a protonating material such as water or an alcohol, similar results can be obtained with the phosphonium and ammonium salts described above, and with the sulfonium and arsonium salts described above but in which the chromophore does not contain a removable, positive hydrogen ion.

The following examples illustrate polymer coatings by photoinduced cationic polymerization of epoxide monomers and prepolymers.

### Example 3.

Phenyl-p-cyanobenzyl-4-[6,7-dimethoxycoumarin methyl] sulfonium trifluoromethanesulfonate (0.1 g) was dissolved in methylene chloride (10 ml) along with cyclohexene oxide (1.0) g and the mixture coated onto a glass substrate and irradiated with visible light from a 200 Watt Hg-Xe 1amp positioned 4" from the substrate. The solution polymerized after exposure to visible radiation for 1 minute and heating at 50°C for 30 minutes. Polymerization was initiated by the Bronsted acid released when the sulfonium salt was irradiated.

### Example 4

Phenyl-p-cyanobenzyl-9-[2-phenylmethyl] anthryl sulfonium trifluoromethane sulfonate (0.2 g) was dissolved in methylene chloride (2ml) along with an epoxy prepolymer (1.0 g). A film of the prepolymer-sulfonium sensitizer composition was formed on a glass substrate by spin coating. The thin film (∼5 micrometers) was irradiated for 2 minutes with a 200 Watt Hg-Xe lamp as previously described. The polymer film became tough and cross-linked after heating at 50°C for 30 minutes. cross-linking was initiated by the Bronsted acid released when the sulfonium salt was irradiated.

### Example 5

Phenyl-p-cyanobenzyl-4-[bifluorenylidene methyl] sulfonium hexafluorophosphate (0.2) was dissolved in methylene chloride (2ml) along with an epoxy prepolymer (1.0 g). A film of the prepolymer-sulfonium sensitizer composition was formed on a glass substrate by spin coating. The thin film (∼5 micrometers) was irradiated for 2 minutes with a 200 Watt Hg-Xe lamp as previously described. The polymer film became tough and cross-linked after heating at 50°C for 30 minutes. Cross-linking was initiated by the Bronsted acid released when the sulfonium salt was irradiated.

The following example illustrates imagewise dye absorption changes as a result of dye protonation.

### Example 6

Phenyl-p-cyanobenzyl-4-[6,7-dimethoxycoumarin methyl] sulfonium trifluoromethanesulfonate (1.0 g) was dissolved in methylene chloride (5 ml) along with polystyrene, MW = 100,000, (1.0 g) and propyl red indicator (0.001 g). A film of the above composition was formed on a 1" round disc (1/8' thick) by spin coating. The polymer film was then exposed to visible light from a Hg-Xe lamp positioned 4" from the substrate for 3 minutes. The initially yellow film turned red after the irradiation was complete as a result of the Bronsted acid released from the sulfonium salt and protonation of the propyl red indicator.

The following example illustrates imagewise conductive films for electrophotographic copying, circuit board fabrication, and fabrication of color filter arrays.

### Example 7

Phenyl-p-cyanobenzyl-4-[6,7-dimethoxycoumarin methyl] sulfonium hexafluorophosphate (0.1 g) was dissolved in methylene chloride (5ml) along with polystyrene, MW = 100,000, (1.0 g). A film of the above composition was cast onto a conductive substrate of either aluminum or nesa (InSnO) glass by spin coating. The solvent was allowed to evaporate in a vaccuum oven with heating (25-50°C for 30 minutes). The polymer film was then exposed to visible light from a Hg-Xe lamp through a mask for 1 minute. The film was then charged with either a positive or negative corona while the conductive layer was held to ground. The ion-charge discharges more rapidly in the irradiated areas due to the presence of a Bronsted acid to produce a latent charged image which can be visualized by the conventional toning procedure. Transfer of the toned image to paper converts it to a permanent state. Additional copies of the charged image can be made by repeating the charging, toning, and transfer process without repeating the exposure step.

The following example illustrates the use of Bronsted photoacids for the production of printing plate masters.

### Example 8 - Printing Plate Masters

4-cyanobenzyl-2-[5-naphthacenyl]benzyl phenyl sulfonium trifluoromethanesulfonate (I) (10% by weight) was dissolved in sufficient acetonitrile solvent along with polyvinyl-(4-t-butylphenylcarbonate) as host polymer (90% by weight) to make a homogeneous solution. A film (∼5 microns) of the polymer-photoacid composite was cast onto a flexible rectangular aluminum substrate 10" x 12" in dimensions. After drying at 50 degrees for 10 minutes, the film was exposed in an imagewise fashion with an argon-ion laser. Development to produce a relief image in the exposed areas was achieved by heating the film to 100 degrees for 5 minutes. The aluminum substrate was then wrapped around a drum with the relief image exposed. The raised pattern could be selectively inked and the inked image transferred to a substrate such as paper. This process could be repeated many times.

## Claims

1. A sulfonium, arsonium, ammonium or phosphonium salt comprising:
a chromophore which absorbs visible radiation, said chromophore exhibiting a higher energy occupied molecular orbital than at least one other substituent attached to the S, As, N or P atom of said salt;
an insulating group which links said chromophore to the S, As, N or P atom of said salt, said insulating group preventing π resonance between said chromophore and the other substituents in said salt;
at least one substituent comprising an electron withdrawing group and exhibiting a lower unoccupied molecular orbital than said chromophore; and,
an anion;
said salt being capable, upon exposure to visible radiation, of forming a Bronsted acid.

2. A salt as claimed in claim 1 which is a sulfonium or arsonium salt wherein the chromophore has a removable positive hydrogen ion, and the salt is capable, upon exposure to visible radiation, of forming, by an intramolecular rearrangement, a Bronsted acid comprising the anion of said salt and said removable hydrogen ion.

3. A salt according to claim 1 or 2 having the formula: 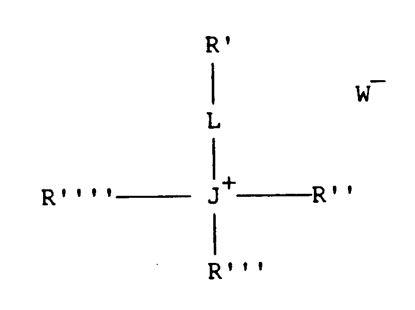 wherein:
R′ represents an electron donating chromophore group which absorbs visible radiation, and which exhibits a higher energy occupied molecular orbital than at least one of R˝, R‴ and R˝˝;
R˝ represents the same substituent as R′ or R‴, an optionally substituted aryl group or an optionally substituted alkyl group having from 1 to 18 carbon atoms;
L represents a linking group which prevents π resonance between R′ and the remainder of the compound;
R‴ represents an electron withdrawing alkyl, aryl or heterocyclic group;
J represents an S, As, N or P atom; and
when J represents As, N or P, R˝˝ represents the same substituent as R′, R˝ or R‴ and, when J represents an S atom, R˝˝ represents O or an electron pair; and,
W⁻ represents an anion capable of forming a Bronsted acid having a pKa of less than 7, said compound being capable, upon exposure to visible radiation of a wavelength absorbed by said chromophore, of forming a Bronsted acid.

4. A salt according to claim 3 wherein the group R′ has a removable positive hydrogen ion, and when J represents a sulfur or arsenic atom wherein when J represents As, R˝˝ represents the same substituent as R′, R˝ or R‴ and when J represents a sulfur atom, R˝˝ represents O or an electron pair; and,
said salt being capable, upon exposure to visible radiation of a wavelength absorbed by said chromophore, of forming, by intramolecular rearrangement, a Bronsted acid comprising W and said removable positive hydrogen of R′.

5. A salt according to any one of claims 1-4 having the formula: 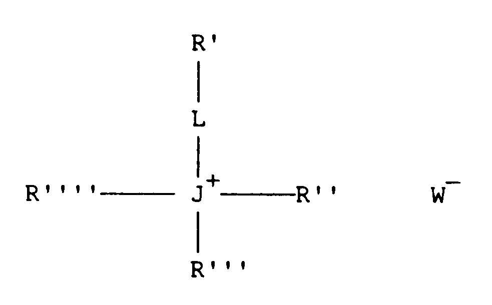 wherein:
R′ represents one of the following chromophores: 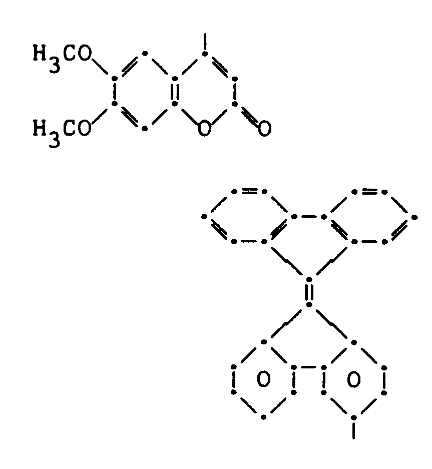 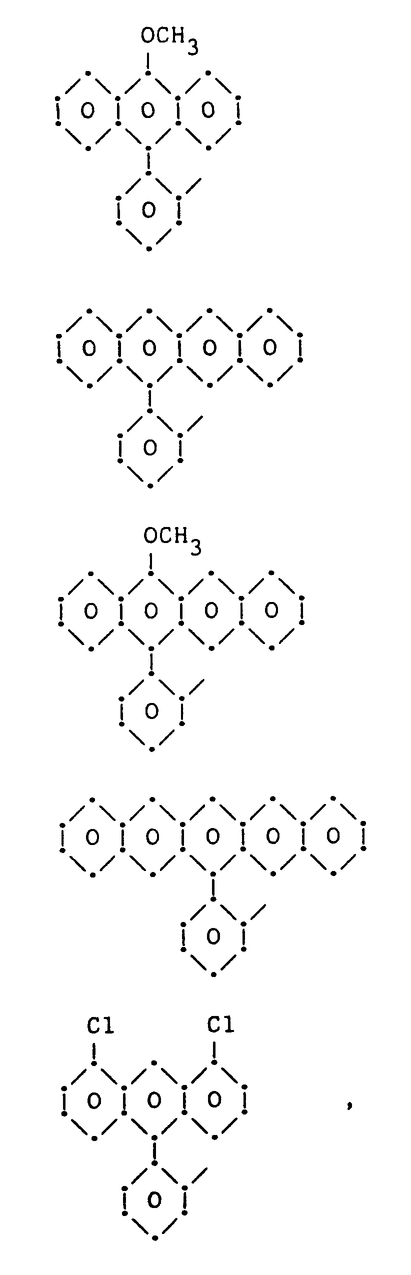 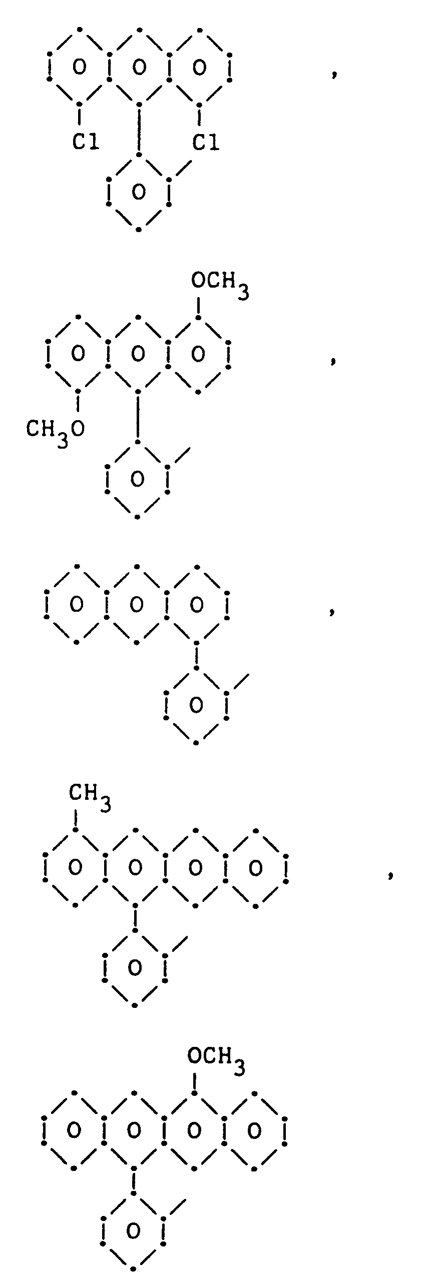 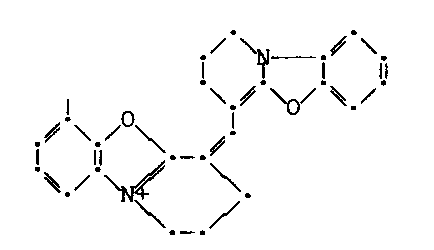 L represents one of the following linkages: 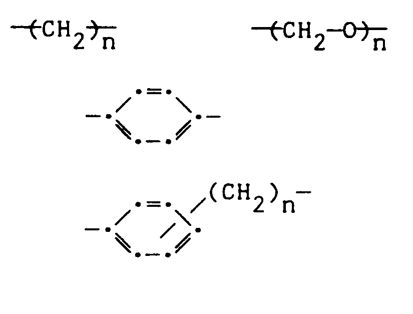
-CO₂-
-CONH-
wherein n represents 1 to 12;
J, R'', R''' and R'''', taken together, represent one of the following groups: 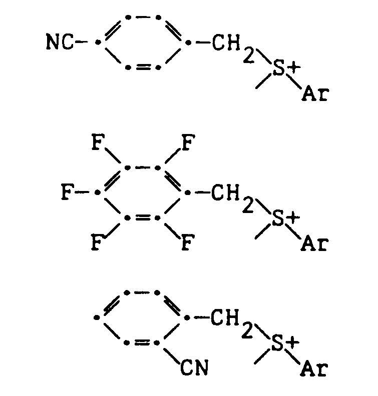 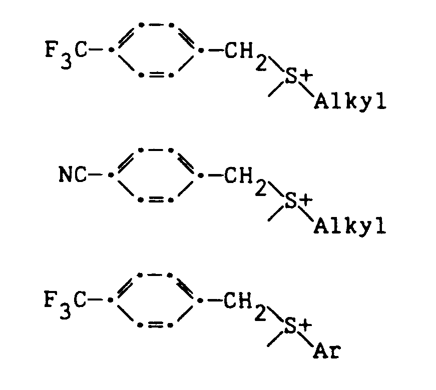 wherein Ar represents an optionally substituent aryl group; and
W⁻ represents BF₄, ClO₄, AsF₆, PF₆, CF₃SO₃, CH₃SO₃, SnCl₄, FeCl₄, BiCl₄ or SbF₆.

6. A salt according to claim 1 consisting of 4-cyanobenzyl-2-[5-naphthacenyl]benzylphenyl sulfonium hexafluorophosphate.

7. A composition comprising a material curable by a Bronsted acid, and a salt according to any one of claims 1 to 6.

8. A composition according to claim 7 comprising about 10% by weight of 4-cyanobenzyl-2-[5-naphthacenyl]benzylphenyl sulfonium hexafluorophosphate and about 90% by weight polyvinyl(4-t-butylphenylcarbonate).

9. A printing plate comprising a substrate having coated thereon a layer comprising a composition according to claims 7 or 8 which in its cured condition is capable of being inked and capable of transferring ink to a substrate.

10. A method of forming images which comprises exposing to visible radiation a composition according to claim 7 or 8.

11. A method of forming images according to claim 10 which comprises exposing to visible laser radiation having a wavelength of about 488-515 nm a layer of a composition according to claim 8.

## Patentansprüche

1. Sulfonium-, Arsonium-, Ammonium- oder Phosphoniumsalz mit:
einem Chromophor, das sichtbare Strahlung absorbiert, wobei das Chromophor ein höher energetisches, besetztes Molekülorbital aufweist als mindestens ein anderer Substituent, der an das S-, As-, N- oder P-Atom des Salzes gebunden ist;
einer isolierenden Gruppe, die das Chromophor an das S-, As-, N- oder P-Atom des Salzes bindet, wobei die isolierende Gruppe eine π-Resonanz zwischen dem Chromophor und den anderen Substituenten in dem Salz verhindert;
mindestens einem Substituenten mit einer Elektronen abziehenden Gruppe, der ein niedrigeres unbesetztes Molekülorbital aufweist als das Chromophor und
einem Anion;
wobei das Salz dazu befähigt ist, bei Exponierung mit sichtbarer Strahlung eine Bronstedsäure zu bilden.

2. Salz nach Anspruch 1, das ein Sulfonium- oder Arsoniumsalz ist, in dem das Chromophor ein entfernbares positives Wasserstoffion aufweist, wobei das Salz dazu befähigt ist, bei Exponierung mit sichtbarer Strahlung durch eine intramolekulare Umlagerung eine Bronstedsäure zu bilden, die das Anion des Salzes und das entfernbare Wasserstoffion aufweist.

3. Salz nach Anspruch 1 oder 2 mit der Formel: 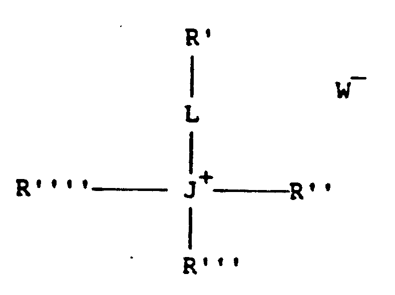 worin bedeuten:
R' eine Elektronen spendende Chromophorgruppe, die sichtbare Strahlung absorbiert und die ein höher energetisches besetztes Molekülorbital aufweist, als mindestens einer der Substituenten R'', R''' und R'''';
R'' den gleichen Substituenten wie R' oder R''', eine gegebenenfalls substituierte Arylgruppe oder eine gegebenenfalls substituierte Alkylgruppe mit 1 - 18 Kohlenstoffatomen;
L eine verbindende Gruppe, die eine π-Resonanz zwischen R' und dem Rest der Verbindung verhindert;
R''' eine Elektronen abziehende Alkyl-, Aryl- oder heterocyclische Gruppe;
J ein S-, As-, N- oder P-Atom; und
wenn J für As, N oder P steht, steht R'''' für den gleichen Substituenten wie R', R'' oder R''', und, wenn J für ein S-Atom steht, steht R'''' für O oder ein Elektronenpaar; und
W⁻ ein Anion, das dazu befähigt ist, eine Bronstedsäure mit einem pKa-Wert von weniger als 7 zu bilden, wobei die Verbindung dazu befähigt ist, bei Exponierung mit sichtbarer Strahlung einer Wellenlänge, die durch das Chromophor absorbiert wird, eine Bronstedsäure zu bilden.

4. Salz nach Anspruch 3, in dem die Gruppe R' ein entfernbares positives Wasserstoffion aufweist, und wenn J ein Schwefeloder Arsenatom darstellt, worin, wenn J für As steht, R'''' den gleichen Substituenten darstellt wie R', R'' oder R''' und worin, wenn J für ein Schwefelatom steht, R'''' für O oder ein Elektronenpaar steht; und
wobei das Salz dazu befähigt ist, bei Exponierung mit sichtbarer Strahlung einer Wellenlänge, die von dem Chromophor absorbiert wird, durch intramolekulare Umlagerung eine Bronstedsäure zu bilden, die W und das von R' entfernbare positive Wasserstoffatom umfaßt.

5. Salz nach einem der Ansprüche 1 - 4 mit der Formel: 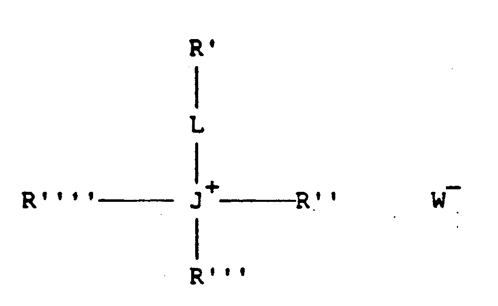 worin:
R' für eines der folgenden Chromophore steht: 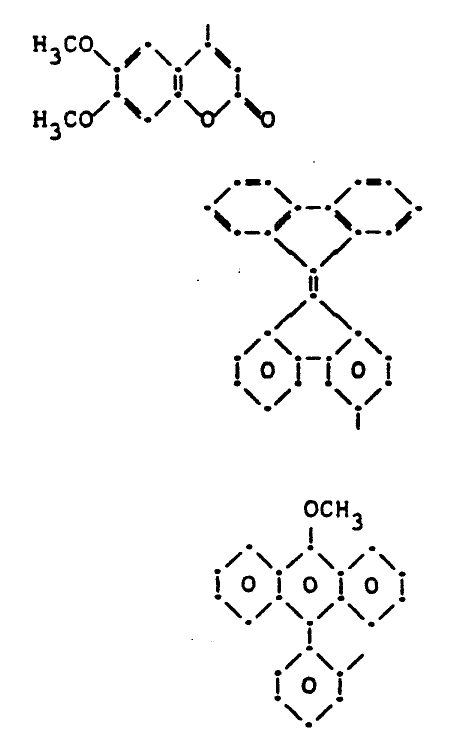 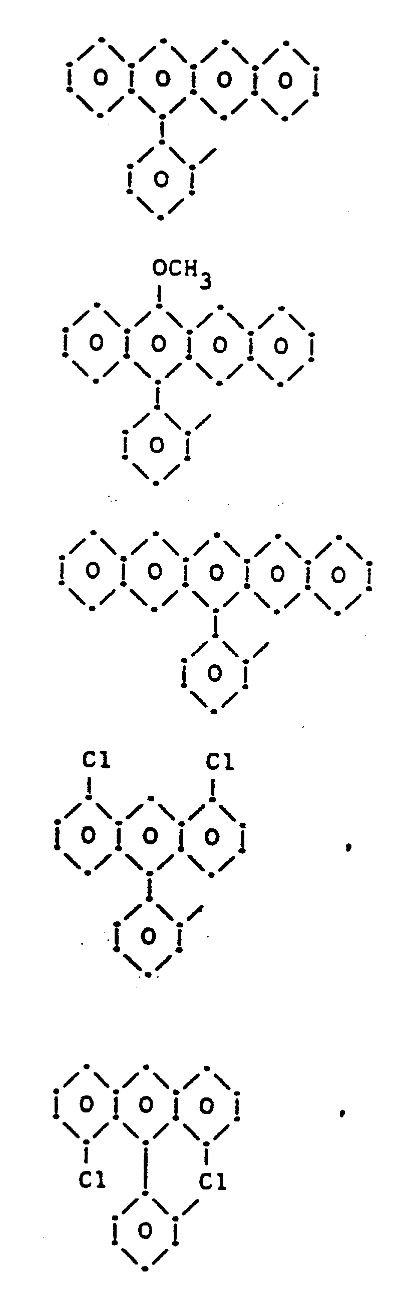 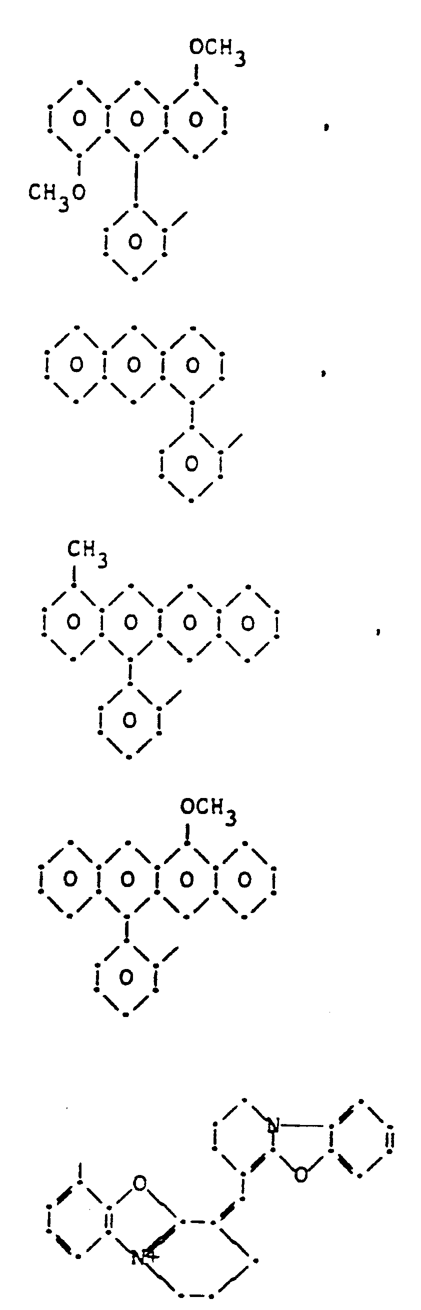 L steht für eine der folgenden verbindenden Gruppen: 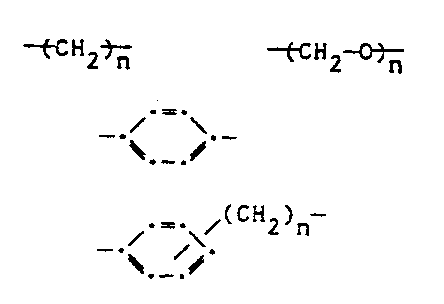
-CO₂-
-CONH-
worin n für eine Zahl von 1 - 12 steht;
J, R'', R''' und R'''' bilden gemeinsam eine der folgenden Gruppen: 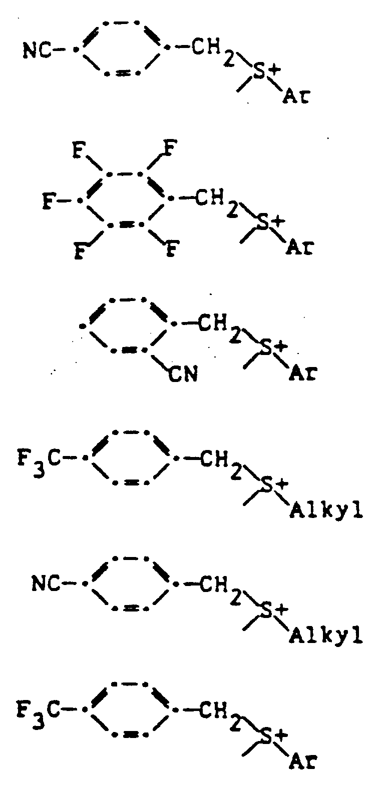 worin Ar für eine gegebenenfalls substituierte Arylgruppe steht; und
W⁻ steht für BF₄, ClO₄, AsF₆, PF₆, CF₃SO₃, CH₃SO₃, SnCl₄, FeCl₄, BiCl₄ oder SbF₆.

6. Salz nach Anspruch 1, bestehend aus 4-Cyanobenzyl-2-[5-naphthacenyl}benzylphenylsulfoniumhexafluorophosphat.

7. Zusammensetzung mit einem Material, das durch eine Bronstedsäure härtbar ist, sowie einem Salz nach einem der Ansprüche 1 - 6.

8. Zusammensetzung nach Anspruch 7 mit etwa 10 Gew.-% 4-Cyanobenzyl-2-[5-naphthacenyl]benzylphenylsulfoniumhexafluorophosphat und etwa 90 Gew.-% Polyvinyl(4-t-butylphenylcarbonat).

9. Druckplatte mit einem Substrat, auf das eine Schicht aufgetragen wurde, die eine Zusammensetzung nach Ansprüchen 7 oder 8 umfaßt, die in ihrem gehärteten Zustand dazu befähigt ist, eingefärbt oder beschriftet zu werden und befähigt ist, die Farbe auf ein Substrat zu übertragen.

10. Verfahren zur Erzeugung von Bildern, bei dem eine Zusammensetzung nach Anspruch 7 oder 8 mit sichtbarer Strahlung exponiert wird.

11. Verfahren zur Herstellung von Bildern nach Anspruch 10, bei dem eine Schicht aus einer Zusammensetzung nach Anspruch 8 einer sichtbaren Laser-Strahlung exponiert wird, die eine Wellenlänge von etwa 488 - 515 nm aufweist.

## Revendications

1. Sel de sulfonium, d'arsonium, d'ammonium ou de phosphonium comprenant :
un chromophore qui absorbe le rayonnement visible, le chromophore ayant une orbitale moléculaire occupée d'énergie supérieure à celle d'au moins un des autres substituants de l'atome de S,As, N ou P du sel ;
un groupe isolant qui relie le chromophore à l'atome de S, As, N ou P du sel, le groupe isolant évitant la résonance π entre le chromophore et les autres substituants du sel ;
au moins un substituant comprenant un groupe attracteur d'électrons et ayant une orbitale moléculaire inoccupée inférieure à celle du chromophore ; et
un anion ;
le sel étant capable, par exposition au rayonnement visible, de former un acide de Brönsted.

2. Sel selon la revendication 1 qui est un sel de sulfonium ou d'arsonium dans lequel le chromophore a un ion hydrogène positif éliminable, et le sel est capable, par exposition au rayonnement visible de former, par réarrangement intramoléculaire, un acide de Brönsted comprenant l'anion du sel et l'ion hydrogène éliminable.

3. Sel selon la revendication 1 ou 2 de formule : 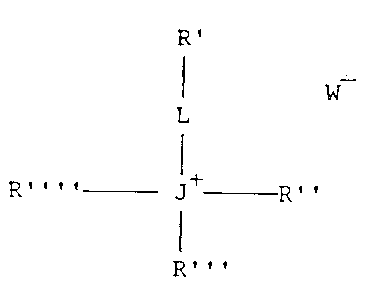 dans lequel
R' représente un groupe chromophore donneur d'électrons qui absorbe le rayonnement visible et qui possède une orbitale moléculaire occupée d'énergie supérieure à celle d'au moins un des groupes R'', R''' et R'''' ;
R'' représente le même substituant que R' ou R''', un groupe aryle ou alkyle qui peuvent être substitués, ayant de 1 à 18 atomes de carbone ;
L représente un groupe de liaison qui évite la résonance π entre R' et le reste du composé ;
R''' représente un groupe alkyle, aryle ou hétérocyclique attracteur d'électrons ;
J représente un atome de S, As, N ou P, et
lorsque J représente un atome de As, N ou P, R'''' est identique à R', R'' ou R''', et, lorsque J représente un atome de S, R'''' représente O ou une paire d'électrons ; et
W⁻ représente un anion capable de former un acide de Brönsted ayant un pKa inférieur à 7, ledit composé étant capable de former un acide de Brönsted lorsqu'il est exposé au rayonnement visible ayant une longueur d'onde absorbée par le chromophore.

4. Sel selon la revendication 3 dans lequel le groupe R' a un ion hydrogène positif éliminable, et J représente un atome de S ou de As, dans lequel lorsque J représente As, R'''' est identique à R', R'' ou R''' et lorsque J représente S, R'''' représente O ou une paire d'électrons, et
le sel étant capable, lorsqu'il est exposé à un rayonnement visible ayant une longueur d'onde absorbée par le chromophore, de former, par réarrangement intramoléculaire, un acide de Brönsted comprenant W et l'hydrogène positif éliminable de R'.

5. Sel selon l'une quelconque des revendications 1 à 4 de formule : 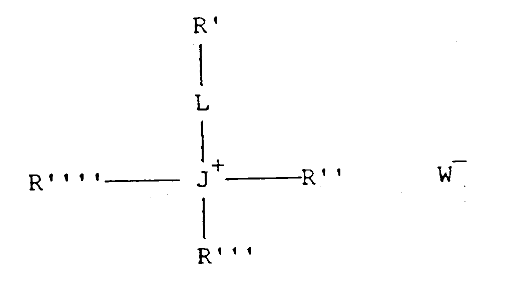 dans laquelle
R' représente un des chromophores suivants : 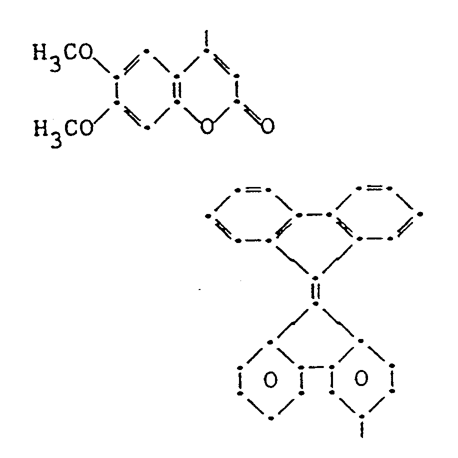 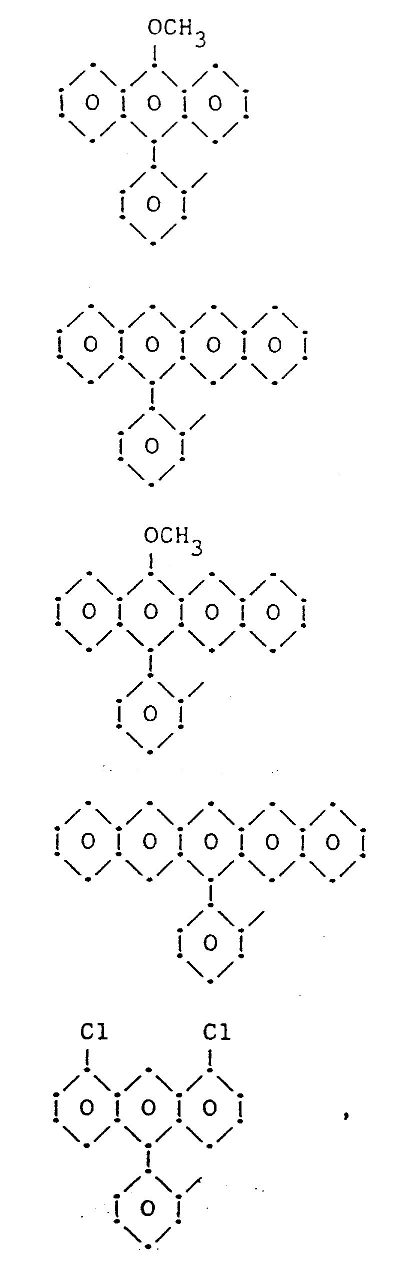 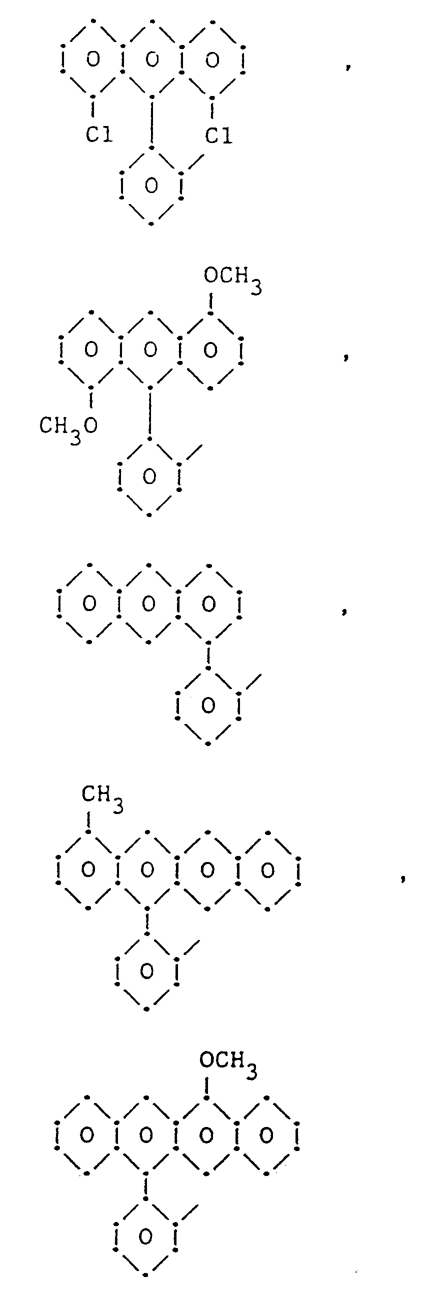 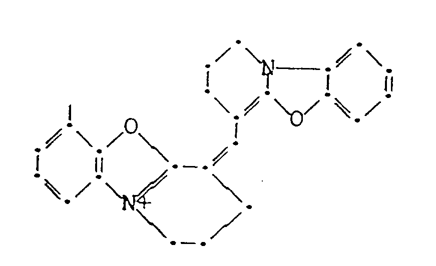 L représente un des groupes de liaison suivants : 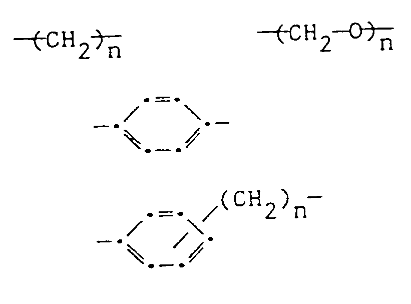
-CO₂-
-CONH-
dans lesquels n est compris entre 1 et 12
J, R'', R''' et R'''' pris ensemble, représentent un des groupes suivants : 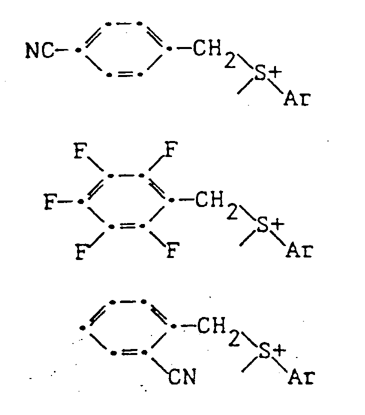 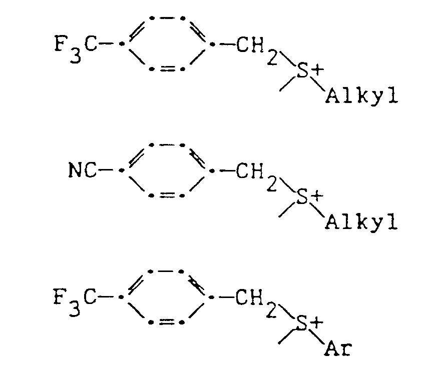 dans lesquels Ar représente un groupe aryle pouvant être substitué et
W⁻ représente BF₄, C10₄, AsF₆, PF6, CF₃SO₃, CH₃SO₃, SnCl₄, FeCl₄, BiCl₄ ou SbF₆.

6. Sel selon la revendication 1 qui est de l'hexafluorophosphate de 4-cyanobenzyl-2-[5-naphthacényl]benzylphényl sulfonium.

7. Composition comprenant un matériau réticulable par un acide de Bronsted et un sel selon l'une quelconque des revendications 1 à 6.

8. Composition selon la revendication 7 comprenant environ 10% en poids d'hexafluorophosphate de 4-cyanobenzyl-2-[5-naphthacényl]benzylphényl sulfonium et environ 90% en poids de polyvinyl(4-t-butylphénylcarbonate).

9. Plaque d'impression comprenant un substrat recouvert d'une couche comprenant une composition selon l'une quelconque des revendications 7 ou 8 qui, une fois réticulée, est capable d'être encrée, et de transférer l'encre sur un substrat.

10. Méthode pour la formation d'images qui comprend l'exposition à un rayonnement visible d'une composition selon l'une quelconque des revendications 7 ou 8.

11. Méthode selon la revendication 10 pour la formation d'images qui comprend l'exposition à un rayonnement visible laser ayant une longueur d'onde comprise entre 488-515 nm d'une couche d'une composition selon la revendication 8.
